Europäisches Patentamt

(19) European Patent Office

Office européen des brevets

(11) Publication number: **0 310 010 B1**

(12) **EUROPEAN PATENT SPECIFICATION**

(45) Date of publication of patent specification: **12.01.94**  (51) Int. Cl.⁵: **H05K  3/46,** H05K 3/38

(21) Application number: **88115951.1**

(22) Date of filing: **28.09.88**

(54) **Multilayer printed circuit board formation.**

(30) Priority: **01.10.87 US 103995**

(43) Date of publication of application:
**05.04.89 Bulletin  89/14**

(45) Publication of the grant of the patent:
**12.01.94 Bulletin  94/02**

(84) Designated Contracting States:
**DE FR GB IT SE**

(56) References cited:
**EP-A- 0 216 531**
**FR-A- 2 361 224**
**US-A- 3 644 166**
**US-A- 4 499 152**
**US-A- 4 512 818**

(73) Proprietor: **MCGEAN-ROHCO, INC.**
**Terminal Tower Building**
**50 Public Square**
**Suite 1250**
**Cleveland Ohio 44113-2251(US)**

(72) Inventor: **Palladino, John Vincent**
**436 Lincoln Avenue**
**Paulsboro New Jersey 08066(US)**

(74) Representative: **Werner, Hans-Karsten, Dr. et al**
**Patentanwälte**
**Von Kreisler-Selting-Werner**
**Postfach 10 22 41**
**D-50462 Köln (DE)**

EP 0 310 010 B1

**Description**

BACKGROUND OF THE INVENTION

The present invention is directed to formation of multilayer printed circuit boards and articles formed thereby.

Multilayer PCB's are typically constructed by interleafing imaged conductive layers such as one containing copper with dielectric layers such as a partially cured B-stage resin, i.e. a prepreg, into a multilayer sandwich which is then bonded together by applying heat and pressure. Since a conductive layer with a smooth copper surface does not bond well to the prepreg, rough copper surfaces have been employed to obtain a better bond to a dielectric. Therefore, a portion of the multilayer PCB industry applies a mechanical roughening process step to assure better bonding. However, as circuit patterns get finer, there is an increasing risk of physically damaging the conductor traces during this surface preparation.

Another process employed by the industry to improve bonding between the conductive layer and the dielectric are various copper surface oxidation procedures widely practiced in the plating industry to assure good interphasial adhesion.

A common drawback for all processes relying mainly on the mechanical interlocking of a rough copper surface with the dielectric is the marginal bond strength with polyimide prepreg and the fact that there is no flexible bonding interphase to absorb the stresses originating from the different thermal expansion coefficients of copper and dielectric which can cause thermal shock failures.

Other technologies to improve bonding of conductive layers to dielectric layers in multilayer boards are described in U.S.Patent 3,536,546, as well as European Patent Application 216,531 (and its corresponding U.S. Serial No. 770,842) and also to U.S. Patent 4,657,632, and involve the deposition of tin on the conductive layer prior to bonding. Whereas these techniques give improved bond strength compared to a copper surface, yield a surface less susceptible to mechanical damage than copper oxide, and required only ambient temperature processing in a less corrosive environment than copper oxide treatments, the resulting bond strengths are considered to be comparable to copper oxide on epoxy prepreg, and inferior to brown oxide on polyimide prepreg. Also the bond strength can deteriorate with time at elevated temperatures, as does the oxide bond. In addition, delamination after solder shock is occasionally observed.

An example of disclosure of a black oxide layer on a copper clad laminate as a step in the process of preparing multilayer circuit boards is disclosed in U.S. Patent 4,512,818. The major drawbacks of these procedures are considered to be marginal bond strength on polyimide prepregs, corrosivity and high temperature processing, a surface coating prone to mechanical damage, partial delamination around through-holes called "pink ring" due to the removal of the bonding oxide layer by aggressive (acidic, reductive) hole cleaning chemicals, and a decay of the bond strength with time at elevated temperatures.

The formation of conductive layer topographies particularly suitable to improved bonding with prepreg without the drawbacks of the oxide treatments have been recently described at the Printed Circuit World Conference IV, Tokyo, Japan, June 2-5, 1987. H. Akahoshi et al (WCIV-9) describe the formation of a surface oxide which gets removed prior to bonding, leaving a copper surface with roughness and bonding characteristics comparable to the oxide surface. Nakaso et al (WCIV-10) describe the formation of a rough conductive layer surface by forming an electroless copper deposit on the conductive layer for better bonding. Silanes, deposited on this clean metallic copper surface are reported to yield a marginal increase in bond strength.

Likewise, U.S. Patent 3,508,983 discloses the use of gamma-amino propyl triethoxysilane to bond copper to a polyester base adhesive in the manufacture of a printed circuit board. This reference emphasizes the point that copper oxide should be removed prior to the silane treatment to affect good bonding.

The most pertinent publication to the present invention is disclosed in U.S. Patent 4,499,152 which discloses formation of a metal laminate with utility of high resolution printed circuit patterns. The laminate preferably contains a resin-bonded, glass reinforced substrate, a layer of coupling agent covering and bonded to a major surface of the substrate and a layer of ultra-thin copper adjacent the layer of coupling agent, and a composite bonding layer dispersed between the copper layer and the layer of coupling agent. A disclosure class of coupling agents includes organosilanes.

SUMMARY OF THE INVENTION

The present invention is directed to a process and article formed thereby for forming a multilayer printed circuit board containing conductive through-holes which make electrical connections to a series of electrically conducting layers through several insulating and dielectric layers comprising the steps of:

(a) forming electrically conductive copper circuitry on a surface of a dielectric layer support with the circuitry having a thickness of at least 4 microns;

(b) forming on the copper circuitry a layer of an oxide, hydroxide or combination thereof of copper or a less noble multivalent metal by (i) conversion of the copper circuitry surface to copper oxide or (ii) application of copper or a less noble multivalent metal to the copper circuitry whereby during application or subsequent thereto the applied metal is converted on its surface to the corresponding oxide, hydroxide or combination thereof with the proviso that during (i) or (ii) the layer of oxide, hydroxide or combination is not greater than 1.5 microns in thickness;

(c) forming an adherent organosilane coating on the surface of the oxide, hydroxide or combination thereof formed in step (b) or on an insulating layer to be bonded to the copper circuitry, the insulating layer comprising a partially cured thermosetting polymer composition;

(d) repeating steps (a), (b) and (c);

(e) bonding materials formed by steps (a), (b), (c) and (d) into a single article whereby an organosilane coating is between a layer of the oxide, hydroxide or combination and an insulating layer whereby during bonding the partially cured insulating layer is cured;

(f) forming a number of holes through the bonded article formed in step (e):

(g) metallizing walls of the through-hole to form electrically conductive paths from opposite openings of the through-hole to form a multilayer circuit board with the proviso that the multllayer printed circuit board will not delaminate upon exposure to thermal stress at 288°C (550°F) for 10 seconds after a preconditioning bake at 135-149°C (275-300°F) for two (2) hours.

In one embodiment of the process of this invention, steps (a) to (d) comprise one insulating layer supporting a layer of copper circuitry, with the proviso that the next step (a) is not repeated in step (d). In an alternative embodiment of this process, the second dielectric layer support of the next step (a), which is repeated in step (d), is the insulating layer.

## DETAILED DESCRIPTION OF THE INVENTION

The present invention is directed to a process for forming a multilayer printed circuit board. The circuit board has alternating layers of dielectric material which support copper circuitry (which may have interspaced other layers such as a copper sheet which serves as a conductive ground plane) which are adhered to an insulating layer through intermediate layers. The circuit board has conductive through-holes which form electrical paths across the entire thickness of the board.

In formation of multi layer circuit boards several dozen conductive and nonconductive layers can be employed. Also, for formation of multilayer circuit boards, it is necessary to drill holes and defects can occur due to delamination of layers in the areas immediately surrounding a hole. If a defect is present in one of the layers or if delamination occurs, generally the entire board must be scrapped. Therefore high quality in each of the steps of formation of the printed circuit board is essential for commercial production.

With the techniques of the present invention, various articles can be formed. Illustratively one article can contain in order, a dielectric layer, copper circuitry with or without a layer of a less noble multivalent metal, an oxide, hydroxide or combintion thereof of the underlying metal, organosilane, an insulating layer, a second dielectric layer, copper circuitry with or without a layer of a less noble multivalent metal, an oxide, hydroxide or combination thereof of the underlying metal, organosilane and a second insulating layer. In the above article the (first) insulating layer can be contacted to the second dielectric layer directly or through an adhesive layer. (Such adhesives are well known in the art, e.g., a high temperature epoxy.)

In an alternate article the second dielectric layer need not be present with all other layers having the same order. In a further alternate embodiment of the invention a dielectric layer can be present which has copper circuitry on opposite surfaces. Thereafter on the opposite surfaces the various layers are applied including optionally a layer of a less noble multivalent metal, an oxide, hydroxide or combination thereof of the underlying metal, organosilane and insulating layer.

For the multilayer circuit board or a portion thereof containing layers bonded together, a conventional test to determine whether an effective bond is formed with or without intermediate layers is a measurement of the bond strength. The force necessary to separate the layers can be measured by an Instron test apparatus. However, in some instances it is found that the bond strength alone is not a sufficiently rigorous test procedure since failure can occur due to the conditions in which a multilayer board is subjected during processing in commercial use. A useful test in accordance with the present procedure is whether delamination will occur at elevated temperature due to thermal stress is described in MIL-P-55110-D. In actual use the outer surface of a multilayer bond is conventionally exposed to molten solder. Although the inner layers may not be exposed to the solder, they are subjected to elevated temperature. Therefore a practical test for broad commercial use to correlate whether the multilayer board can be used for general widespread commercial application is one or more tests set forth in MIL-P-55110-D.

One of the tests in MIL-P-55110-D requires thermal stress at 288°C (550°F) for 10 seconds after a pre-conditioning bake at 135-149°C (275-300°F) for two (2) hours. The specimen. i.e., the article, is visually inspected for cracking of plating, separation of plating and conductors. blistering or delamination. Laminate voids with the largest dimension of 0.08mm (0.003 inch) or less are permitted provided the conductor spacing is not reduced below the minimum dielectric spacing, laterally or vertically. In a more preferred mode for a more stringent test, a time period of 60 seconds is employed rather than 10 seconds.

In another mode for the test procedure the final multilayer circuit board meets all applicable test procedures of MIL-P-51110D.

One reason why this test is applicable to commercial use is due to the diversity of materials employed in the multilayer construction. Although copper is the metal of choice in formation of conductive circuitry, dielectric and insulating layers (which can be of the same material with dielectric employed in the present context to refer to the initial support for a copper sheet which is formed into circuitry while insulating layer refers to another layer to which the circuitry is bonded through intermediate layers) material can drastically differ. Examples of preferred materials are epoxy and polyimide.

A starting material in the present invention is a dielectric layer which contains on one or opposite surfaces a cladding of copper. This copper layer is of a thickness of at least 4 microns and more preferably 32 microns and it is used to form conductive circuitry. Well-known techniques in the prior art can be employed to form such circuitry such as by photoimaging technique of a photosensitive resist film followed by etching of unprotected areas of the copper. An example of a suitable technique is disclosed in U.S. Patent 3,469,982. The composition of the dielectric layer is not critical provided it functions as an electrical insulator. Useful support materials are disclosed in U.S. Patent 4,499,152 such as epoxy reinforced with glass fiber. Preferably a partially cured thermosetting polymer composition is employed which is known in the art as a prepreg or "B" stage resin. Use of such polymer composition adds in subsequent bonding operations.

After formation of the conductive circuitry, it is necessary to form a thin outer layer of an oxide, hydroxide or combination thereof. This layer which is of a thickness not greater than 1.5 microns and more preferably not greater than 1.0 microns can be directly formed by oxidation of the copper circuitry. Well-known techniques used to form so-called "brown" or "black" oxide coatings can be employed. However major problems have been encountered due to a phenomenon known as pink ring formation whereby the oxide is dissolved or is at least partially destroyed due to later required processing steps. Significant research efforts have been undertaken to solve this pink ring effect. Also in formation of oxide coatings corrosive chemicals have been employed which causes problems due to the use of harsh chemicals with special processing necessary. However it is within the scope of the present invention that such oxide is employed. If a metal other than copper is employed the oxide layer can be extremely thin, e.g., 0.1 microns or less and can be about one or two angstroms.

In a more preferred embodiment a conductive layer is formed from a multivalent metal which is less noble than copper (copper could also be employed). As will be more fully described below, a preferred technique of application of the coating is by immersion metal plating. The thickness of the metal layer is not critical and can be, e.g. 0.15 to 0.25 microns. During, and subsequent to, the application of the metal, a thin coating of an oxide, hydroxide or combination thereof is formed. Since this coating can be extremely thin, not greater than 1.5 microns in the case of copper or in some instances only monolayers in thickness, air oxidation can be employed. In such case, the oxide/hydroxide can be formed upon standing at room temperature wherein the copper surface reacts with ambient oxygen and water vapor. Other techniques for formation of the oxide/hydroxide include immersion in or exposure to an oxidative aqueous bath.

An organosilane is applied as a coating either to the oxide, hydroxide or combination or to a partially cured thermosetting polymer composition, also known in the art as a prepreg or "B" stage resin. The same materials of construction as the dielectric layer can be employed for this layer which is termed an insulating layer to more readily distinguish the layers from one another. Turning to the silane which can be employed in the present invention, it is a requirement that the silane forms an adherent intermediate layer which bonds this oxide, hydroxide or combination thereof to the partially cured and converted to the fully cured insulating layer. It is a requirement that the silane functions to prevent delamination in accordance with the thermal stress test as defined herein. In a preferred mode the multilayer circuit board with fully cured insulating layer meets all specifications of MIL-P-55110D.

Turning to organosilane, it is considered to form hydrogen bridge bonds with silanol (Si-OH)-groups of the silane and/or form covalent metal -O-Si bonds in a condensation reaction. The silanes are considered to interact with the adjacent layers through a functionally substituted organic group to provide van der Walls force interaction, strong polar force/hydrogen bridge interaction, or covalent bond formation with the dielectric resin.

Organo silanes containing a functionally substituted organic group are compounds of the general structure

$$R''_n SiA_{4-n}$$

wherein each $R''$ independently of the other is hydroxyl or a hydrolyzable group, each A independently of the other is $C_1$ to $C_{10}$ alkyl or a saturated, unsaturated or aromatic hydrocarbon residue functionalized by at least one member selected from the group consisting of amino, carbonyl, carboxy, isocyano, azo, diazo, thio, thia, dithia, isothiocyano, oxo, oxa, halo, ester, sulfhydryl, imido, amido, sulfoamido, and n is 1, 2, or 3.

A particularly preferred class of organosilanes are those wherein:

$R''$    is $-OR_1$ wherein $R_1$ is $-H$, $-CO-R_2$,
       $-SO_2-R_2$ and wherein $R_2$ is
       $C_1-C_5$ alkyl or substituted $C_1-C_5$ alkyl;
       $-O-C_aH_{2a+1}$ wherein a is an integer from 1 to 12;
       $-O-C_bH_{2b}-R_3$ wherein b is an integer from 1 to 12 and wherein $R_3$ is $-H$, $-OH$, $-CO-R_4$ wherein $R_4$ is a $C_1-C_5$ alkyl or a substituted $C_1-C_5$ alkyl;
       $-Cl$ or $-Br$;

A    is $-R-R^1$;

R    is $-CH=CH-$, $-C_xH_{2x}$ wherein x is O or an integer of 1 to 5; and

$R'$    is a $C_1-C_5$ alkyl or when x is an integer of 1 to 5, $-H$; a polar terminal group consisting essentially of ureido, amino, hydroxy, mercapto, carboxy and carboxylate ester; or an epoxy terminal group.

In the practice of this invention the organosilanes may be applied as a liquid or solution to the metal hydroxide/oxide surface or the insulating layer surface by any conventional means, e.g., by dipping, spraying, brushing, immersion, etc.

The immersion metal coatings disclosed in European Patent 216,531 and its corresponding U.S.S.N. 770,842 as well as U.S. Patent 4,657,632 are directly useful in the present invention for initial bonding to the copper circuitry. These publications are incorporated by reference herein. However, it is considered that the immersion metal coatings are insufficient to form a direct bond between the electrically conductive layer copper surface and a dielectric material since delamination can occur particularly due to thermal stress. The organosilane has the ability to increase the bond strength. A preferred coating composition contains a thiourea compound, a metal salt, a reducing agent, an acid and a urea compound. In accordance with the teachings of these prior art publications a urea compound is necessary. However a urea compound is not necessary with an organosilane layer. Therefore it is directly within the scope of the present invention that wherever the term urea compound is present in reference to the above publications it can be deleted. Therefore similar formulations can be directly employed as disclosed in these publications except the urea compound can be omitted. In a preferred embodiment the urea will be present.

Since in a preferred embodiment compositions which employ a thiourea compound, a metal salt, a reducing agent, an acid and a urea compound, pertinent disclosure for these publications is reproduced herein. With reference to these publications a preferred metal salt is selected from the group of salts based on the Group IVA metals including tin, Group VIII metals, Group IB metals, Group IIB metals and Group IIIA metals, with a preferred metal being tin.

The tin salt preferably comprises a stannous salt. Although stannous salts of an inorganic (mineral) acid or organic acid may be used, ( e.g., stannous formate, stannous acetate and the like) the tin salt may comprise a stannous salt of a mineral acid such as the sulfur, phosphorous, and halogen acids, especially the sulfur acids such as sulfuric acid or sulfamic acid. Alkali metal stannates may also be used such as sodium or potassium stannate and the art known equivalents thereof. In one embodiment stannous sulfate, stannous sulfamate or stannous acetate is used as the tin salt. Where tin lead coatings are deposited, lead acetate may be used as the lead salt.

The acids that are employed may be organic acids or inorganic acids (mineral acids) based on sulfur, phosphorous, or the halogens, the sulfur based mineral acids being preferred such as sulfuric acid or sulfamic acid. Some of the organic acids that may be employed comprise monocarboxylic or dicarboxylic acids having up to about six carbon atoms such as formic acid, acetic acid, malic acid, maleic acid, and the like.

It is preferred, if possible not to use halogen acids or halogen salts since halide residues will be produced in the metal coating deposited, these salts interfering with the electrical properties of the metal and may also act as corrosive materials in the coating.

The chelating agents that may be employed generally comprise the various classes of chelating agents and specific compounds disclosed in Kirk-Othmer, Encyclopedia of Chemical Technology, Third Edition, Volume 5, pages 339-368 incorporated herein by reference. Chelating agents that are especially preferred comprise the aminocarboxylic acids and the hydroxycarboxylic acids. Some specific aminocarboxylic acids that may be employed in this respect comprise ethylenediaminetetraacetic acid, hydroxyethylenediaminetriacetic acid, nitrilotriacetic acid, N-dihydroxyethylglycine, and ethylenebis-(hydroxyphenylglycine). Hydroxy carboxylic acids that may be employed comprise tartaric acid, citric acid, gluconic acid and 5-sulfosalicylic acid.

The various reducing agents that may be employed are well known in the art and generally comprise organic aldehydes whether saturated or unsaturated, aliphatic or cyclic, having up to about ten carbon atoms. Lower alkyl aldehydes having up to about six carbon atoms may be employed in this respect such as formaldehyde, acetaldehyde, propionaldehyde, butyraldehyde, and the like. Especially preferred aldehydes comprise hydroxy aliphatic aldehydes such as glyceral-dehyde; erythrose; threose; arabinose and the various positions isomers thereof and glucose and the various position isomers thereof. Glucose has been found to act to prevent oxidation of the metal salts to a higher oxidation state, e.g., SnII to SnIV, but also as a chelating agent and is especially useful for these reasons.

The surfactants that may be employed comprise any non-ionic, anionic, cationic or amphoteric surfactant such as those listed in Kirk-Othmer, Encyclopedia of Chemical Technology, Third Edition. Volume 22, pp. 332-387 which is incorporated herein by reference. The non-ionic surfactants are especially preferred.

The process which the immersion metal coatings can employ metal oxide/hydroxide layers other than tin. Nickel, copper and lead are multivalent metals which are no more noble than copper and fall within the same classification. Gold on the other hand is more noble than copper and is outside the present disclosure.

The surface area of the metal oxide/hydroxide layer to which the hydrolyzed silane is applied is a factor in the resulting bond strength. Thus high surface areas such as produced by oxidizing a copper surface to copper oxide, then hydrolyzing the oxide and conversion to tin oxide by an immersion process give a high surface area which gave the highest bond strength when bonded to polyimide after the silane treatment.

Preferred classes of silanes include aminoalkylsilanes, ureidoalkylsilane ester and epoxyalkylsilane esters. More specific examples are contained in Example 3 below.

In accordance with the present invention is a requirement that the bonding of the metal layer which is generally supported by an insulating layer to a dielectric layer can withstand a solder float test.

After having bonded the various layers of a multilayer construction by applying pressure and heat in a lamination press holes (for electrical interconnect) are drilled through the multilayer, typically using a numerically controlled drilling machine with multiple heads and air bearings. Such drilling operations are described, e.g., in Handbook of Printed Circuit Design, Manufacture, Components and Assembly. (Chapter 4.3.2 pg. 254) by G. Leonida, Electrochemical Publications, 1981 and Printed Circuits Handbook (Chapter 5.8-5.12) Edited by Clyde F. Coombs. Jr., McGraw-Hill Book Co., 2nd Edition.

Well known techniques for hole formation and making the hole conductive can be employed herein, e.g., see Printed Circuit Technology, edited by N.S. Einarson, 1977, Chapter 7.

To further define the present invention the following examples are provided. In these examples all parts and percentages are by weight and degrees are in Centigrade unless otherwise described. In the examples, copper foil was employed as a sheet rather than processed to form circuitry. The use of a copper sheet was considered to denote more reproductivity in test measurements. Also, in the examples, hole drilling was not employed which likewise was considered to allow greater reproductivity to test results.

## EXAMPLE 1

Copper foil, 35μm (1.4 mil) thick (20,4 g(1 oz. copper) was chemically cleaned, treated with an immersion tin composition and a silane coupling agent, gamma-ureidopropyltriethoxysilane, and evaluated versus an immersion tin composition (see below) without a silane coupling agent and a commercial brown oxide.

The solutions, temperatures and time of treatment were as follows:

EP 0 310 010 B1

| Step # | Solution | Temp. | Time |
|---|---|---|---|
| 1 | Hot Soak Cleaner (Electrochemicals 402) | 49°C | 4 min |
| 2 | Overflow Water Rinse | 20°C | 3 min |
| 3 | Stagnant Water Rinse | | 3 min |
| 4 | Sodium Persulfate Etch (1,27μm (50 microinches) per three minutes) | 38°C | 3 min |
| 5 | Water Rinse | | |
| 6 | 10% H$_2$SO$_4$ volume basis | 20°C | 1 min |
| 7 | DI* Water Rinse | 20°C | 1 min |
| 8 | Immersion Tin Composition | 20°C | 1 min |
| 9 | Overflow Water Rinse | 20°C | 1 min |
| 10 | Stagnant Water Rinse | | 1 min |
| 11 | Turbine Dryer | | 7 min |

*DI means deionized

In Step 8 the immersion tin composition was formed by mixing Solution A and Solution B of the following composition

| Solution A | |
|---|---|
| D.I. water | 200 ml |
| Conc. H$_2$SO$_4$ | 100 ml |
| Hypophosphorus acid (50%) | 40 ml |
| Stannous Sulfate | 20 g |
| D.I. Water | To 0.5 liter |

| Solution B | |
|---|---|
| Thiourea | 60 g |
| Urea | 40 g |
| D.I. Water | to 0.5 liter |

22,7 litres (Six gallons) of 0.5% solution of Union Carbide A-1160 (50% active in Methanol) gamma-ureidoproplytriethoxysilane coupling agent were prepared by first adjusting the pH of about 18,9 litres ( 5 gallons) of deionized water to approximately 3.5 with dilute acetic acid. One hundred twenty-six grams of silane coupling agent was added with stirring. The solution was allowed to stand approximately 15 minutes to insure complete hydrolysis of silane to a silane triol.

Samples of copper treated with the immersion tin composition were dipped into the silane solution for approximately 15 seconds and removed. Excess solution was allowed to drain and the samples dried in a turbine drier set at 105-110°C for 7 minutes. Samples of copper treated with the immersion tin composition was also prepared without silane treatment. These samples were used as controls. Also used as controls, were samples of copper foil (chemically cleaned) some of which were treated with silane solution. An added control was copper treated with brown oxide, an industry standard for multilayer boards.

Those treated with oxide were processed as follows:

| OXIDE TREATMENT CYCLE | | | |
|---|---|---|---|
| Step # | Solution | Temp. | Time |
| 1 | Hot Soak Cleaner (Electrochemicals 402) | 49°C | 4 min |
| 2 | Overflow Water Rinse | 20°C | 3 min |
| 3 | Stagnant Water Rinse | 38°C | 3 min |
| 4 | Sodium Persulfate Etch 1,27 $\mu$m per three minutes (50 microinches per three minutes) | 20°C | 3 min |
| 5 | Stagnant Water Rinse | | |
| 6 | Sodium Hydroxide 1% by | 20°C | 2 min |
| 7 | Brown Oxide (Electrochemicals 499) | 74°C | 6 min |
| 8 | Overflow Water Rinse | 20°C | 3 min |
| 9 | Stagnant Water Rinse (warm) | | 3 min |
| 10 | Turbine Dryer | | 7 min |

Several samples of oxide treated copper, were also treated with silane solution and hot air turbine dried at 105-110°C for 7 minutes after treatment.

Laminates were prepared by first heating all treated and untreated copper foil samples to 121-132°C (250-270°F) for 1 hour. This exposure was considered to simulate conditions actual laminates would be subjected to prior to preparation of a multilayer board. The higher temperature and time assured removal of moisture which could result in delamination during manufacturing of the multilayer boards.

The heat-treated foil samples were then placed in contact with a layer of "B" stage epoxy or polyimide resin and processed to develop bonding.

Epoxy

Polyclad Prepreg Type 1080 or 2116 - 4 plies used 1080 contains approximately 65 ± 5% resin content
    with fine weave glass cloth
2116 contains approximately 55 ± 5% resin content
    with heavy weave glass cloth

Lamination Conditions

Preheat hydraulic press to 177°C ± 3°C (350°F ± 5°F.) Load and center package as rapidly as possible, then close platens and apply pressure of 2,069•$10^6$ Pa (300 psi) immediately. Allow to cure at full pressure for approximately 60 minutes. Cool load under full pressure to 66°C (150°F) or less, then remove from press and allow to cool to room temperature.

Polyimide

"B" stage or prepreg - Type 1080 or 2116 - 2 sheets
    used
1080 contains approximately 60 ± 5% resin content with
    fine weave glass cloth
2116 contains approximately 47 ± 5% resin content
    with heavy weave glass cloth

Lamination Conditions

Place samples in press set at 177°C (350°F). Immediately apply pressure of 2,55•$10^6$ Pa (370 psi). Hold temperature and pressure for 3 hours, then increase temperature to 221°C (430°F). Hold for 4 hours at 2,55•$10^6$ Pa (370 psi). Cool to 121°C (250°F) over a 1 hour period, maintaining 2,55•$10^6$ Pa (370 psi). Further cool to room temperature without pressure.

Samples of both epoxy and polyimide laminate are then processed to obtain 0,64 cm (1/4")wide strips for peel or bond strength determination.

## RESULTS

| Desig-nation | Composition | Bond Strength (lb/inch) | g/cm |
|---|---|---|---|
| A | Copper foil, no treatment + 1080 epoxy | (1.6) | 286 |
| B | Copper foil treated with A-1160 silane + 1080 epoxy | (1.6) | 286 |
| C | Copper foil, immersion tin treated + 1080 epoxy | (4.0) | 714 |
| D | Copper foil, immersion tin treated + A-1160 treatment + 1080 epoxy | (7.6) | 1357 |
| E | Brown Oxide + 1080 epoxy | (4.4) | 786 |
| F | Brown Oxide + A-1160 silane + 1080 epoxy | (7.2) | 1286 |
| G | Copper foil treated with immersion tin + 2116 epoxy | (3.6) | 643 |
| H | Copper foil treated with immersion tin + A-1160 silane treatment + 2116 epoxy | (7.2) | 1286 |
| I | Brown Oxide + 2116 epoxy | (5.2) | 929 |
| J | Brown Oxide + A-1160 silane + 2116 epoxy | (5.6) | 1000 |
| K | Copper foil, no treatment + 1080 polyimide | No reading | |
| L | Copper foil + A-1160 silane + 1080 polyimide | No reading | |
| M | Copper foil + immersion tin treatment + 1080 polyimide | No reading | |
| N | Copper foil + immersion tin treatment + A-1160 silane treatment + 1180 polyimide | (2.0) | 357 |
| O | Brown Oxide + 1080 polyimide | (1.2) | 214 |
| P | Brown Oxide + A-1160 silane treatment + 1080 polyimide | (2.8) | 500 |
| Q | Immersion tin treated copper + 2116 polyimide | 0 | |
| R | Immersion tin treated copper + A-1160 silane treatment + 2116 polyimide | (3.2) | 572 |
| S | Brown Oxide + 2116 polyimide | (0.8) | 143 |
| T | Brown Oxide +A-1160 silane treatment + 2116 polyimide | (2.4) | 429 |

NOTE FOR FOLLOWING EXAMPLES -
    (1) In the following examples the term "Immersion Tin" where used alone refers to the Immersion Tin Composition of Example 1.

9

(2)  Bond or peel strength determination were made on an Instron Tensile Tester, (Instron Eng. Corp., Quincy, Mass., U.S.A.) Model TT-B with a crosshead speed of (2 inches/minute). The Instron Unit was in an environmentally controlled area at (70°F ± 5°F) and 50% ± 10% relative humidity. Sample width was as noted in the example.

EXAMPLE 2

Four sets of 6-layer multilayers were prepared.

| Set # | Process Condition |
|---|---|
| 0 | Electrochemicals 499 brown oxide treated copper foil |
| 1 | Electrochemicals 499 brown oxide treated copper foil further treated with 0.5% solution of A-1160 silane coupling |
| 2 | Immersion tin composition treated copper foil further treated with 0.5% solution of A-1160 silane coupling agent |
| 3 | Immersion tin treated composition copper foil - no silane treatment |

Those treated with the immersion tin composition were processed as follows:

| TREATMENT CYCLE | | | |
|---|---|---|---|
| Step # | Solution | Temp. | Time |
| 1 | Hot Soak Cleaner (Electrochemicals 402) | 49°C | 4 min |
| 2 | Overflow Water Rinse | 20°C | 3 min |
| 3 | Water Rinse | 38°C | 3 min |
| 4 | Sodium Persulfate Etch 1,27 μm per three minutes (50 microinches per three minutes) | 20°C | 3 min |
| 5 | Stagnant Water Rinse | | |
| 6 | 10% $H_2SO_4$ value basis | 20°C | 1 min |
| 7 | D.I. Water Rinse | 20°C | 1 min |
| 8 | Immersion tin composition as in Example 1 | 20°C | 1 min |
| 9 | Overflow Water | 20°C | 1 min |
| 10 | Stagnant Water Rinse | | 1 min |
| 11 | Turbine Dryer | | 7 min |

| OXIDE TREATMENT CYCLE | | | |
|---|---|---|---|
| Step # | Solution | Temp. | Time |
| 1 | Hot Soak Cleaner (Electrochemicals 402) | 49°C | 4 min |
| 2 | Overflow Water Rinse | 20°C | 3 min |
| 3 | Stagnant Water Rinse | 38°C | 3 min |
| 4 | Sodium Persulfate Etch 1,27 μm per three minutes (50 microinches per three minutes) | 20°C | 3 min |
| 5 | Water Rinse | 20°C | 3 min |
| 6 | Sodium Hydroxide 1% | 20°C | 2 min |
| 7 | Brown Oxide (Electrochemicals 499) | 74°C | 6 min |
| 8 | Overflow Water as in Example 1 | 20°C | 3 min |
| 9 | Stagnant Water Rinse (warm) | | 3 min |
| 10 | Turbine Dryer | | 7 min |

Following cleaning of copper foil and treatment in either oxide or immersion tin, one brown oxide set and one immersion tin set were treated in a 0.5% solution of A-1160 silane coupling agent. The coupling agent solution was prepared by adjusting deionized water to pH 3.5-4.5 with acetic acid. Coupling agent was then added, with stirring, and allowed to hydrolyze for at least 15 minutes. The test panels were immersed in the silane solution for approximately one minute, removed and allowed to air dry followed by turbine dry for approximately 7 minutes.

All sets, silane treated as well as untreated samples were then baked horizontally for 1 hour at 127°C (260°F) followed by lamination to Polyclad Type 1080 epoxy prepreg.

Samples were then processed through a multi layer operation in accordance with Example 1. After pattern plating, the resist was stripped and panels etched. Horizontal and vertical cross-sections were prepared and examined.

Sets 0 and 1 contained 152-254 μm (0.006" - 0.010") of pink ring - silane treatment did not reduce pink ring. Sets 2 and 3 showed no sign of pink ring. Plated-throughhole quality was good on all samples. There was no evidence of delamination or separation in any of the cross-sections prior to thermal stress.

Visual inspection of each panel prior to infra red (IR) reflow indicated no delamination. All panels were then baked for 2 hours at 149°C (300°F) prior to IR reflow. After reflow, Panel #3 exhibited delamination, particularly concentrated around the plated-throughholes. Panels #0, 1 and 2 did not delaminate or separate.

Prior to reflow, 5cm x 10cm (2 inch x 4 inch) samples were sheared from all panels and baked for 4 hours at 141°C (285°F). The samples were then dipped in Argus fusing fluid for 30 seconds at 21°C (70°F) and solder floated for 10 seconds at 288°C (550°F) (see MIL P-55110-D). Samples were then sheared in half. redipped in fusing fluid for 30 seconds and solder floated again for 50 seconds at 288°C (550°F). The visual appearance of the samples of the solder floating are described below.

| Panel # | 10 seconds at 288°C (550°F) | 60 seconds 288°C (550°F) |
|---|---|---|
| 0 | No delamination | No delamination |
| 1 | No delamination | No delamination |
| 2 | No delamination | No delamination |
| 3 | Localized delamination around plated throughholes | Massive delamination |

A cross-section of the same pattern of plated throughholes was taken from all panels after 60 seconds at 288°C (550°F)solder float. Cross-sections #0, #1, and #2 showed no delamination. Cross-section #3 exhibited separations between the immersion tin and the epoxy prepreg in several locations.

EXAMPLE 3

In this example, silane coupling agents were evaluated as bond enhancement agents for the bonding of immersion tin treated copper to epoxy and polyimide "B" stage or prepreg.

Solutions of silane coupling agents were prepared by first adjusting the pH of deionized water to 3.5 to 4.5 with dilute acetic acid. The silane coupling agent was then added, with stirring, at the indicated concentrations. Solutions were then allowed to hydrolyze for approximately 15 minutes before use.

Samples of copper foil, approximately 35 $\mu$m (1.4 mil) thick and 5cm x 15cm (2" x 6") in dimension were cleaned prior to treatment with the immersion tin composition of Example 1. The cleaning procedure was as follows:

1. AC-500 (Du Pont) acidic cleaner - 3 minutes @ 54°C (130°F)
2. Two - 1 minute cold water rinses
3. Microtech - two minutes at room temperature with sodium persulfate
4. Two - 1 minute cold water rinses
5. 1 minute dip in 10% by volume sulfuric acid at room temperature
6. 1 minute cold water rinse
7. Dry

Cleaned copper samples were then dipped in a room temperature (approx. 20°C) solution of the immersion tin composition of Example 1 for 60 seconds. rinsed with room temperature water for approximately 2 minutes then dried.

Additional samples of cleaned copper were treated with commercially available brown and black oxides for use as controls. The brown oxide treatment. McDermitts MACuBond, and Shipley Chemicals SHIPLEY ProBond 80A black oxide were applied using procedures outlined in the respective product bulletins.

The following silane coupling agents, of the type R-Si(X)$_3$ were evaluated at the indicated concentration after dilution with water.

| Sample No. | Product Identification | % Conc. | R Group | X Group |
|---|---|---|---|---|
| 1 | A-151 (U.C.) | 0.5 | $C_2H_3-$ | $(OC_2H_5)$ |
| 2 | A-151 (U.C.) | 1.0 | $C_2H_3-$ | $(OC_2H_5)$ |
| 3 | A-186 (U.C.) | 0.5 | (thiirane ring)$-(CH_2)_3-$ | $(OCH_3)$ |
| 4 | A-186 (U.C.) | 1.0 | (thiirane ring)$-(CH_2)_3-$ | $(OCH_3)$ |
| 5 | A-187 (U.C.) | 0.5 | $CH_2CHCH_2O(CH_2)_3-$ | $(OCH_3)$ |
| 6 | A-187 (U.C.) | 1.0 | $CH_2CHCH_2O(CH_2)_3-$ | $(OCH_3)$ |
| 7 | A-1100 (U.C.) | 0.5 | $H_2N(CH_2)_3-$ | $(OC_2H_5)$ |
| 8 | A-1100 (U.C.) | 1.0 | $H_2N(CH_2)_3-$ | $(OC_2H_5)$ |
| 9 | A-1102 (U.C.) | 0.5 | $H_2N(CH_2)_3-$ | $(OC_2H_5)$ |
| 10 | A-1102 (U.C.) | 1.0 | $H_2N(CH_2)_3-$ | $(OC_2H_5)$ |
| 11 | A-1110 (U.C.) | 0.5 | $H_2N(CH_2)_3-$ | $(OCH_3)$ |
| 12 | A-1110 (U.C.) | 1.0 | $H_2N(CH_2)_3-$ | $(OCH_3)$ |
| 13 | A-1120 (U.C.) | 0.5 | $NH_2(CH_2)_2N(CH_2)_3-$ | $(OCH_3)$ |
| 14 | A-1120 (U.C.) | 1.0 | $NH_2(CH_2)_2N(CH_2)_3-$ | $(OCH_3)$ |
| 15 | A-1130 (U.C.) | 0.5 | $NH_2(CH_2)_2NH(CH_2)_2NH(CH_2)_3-$ | $(OCH_3)$ |
| 16 | A-1130 (U.C.) | 1.0 | $NH_2(CH_2)_2NH(CH_2)_2NH(CH_2)_3-$ | $(OCH_3)$ |
| 17 | A-1160 (U.C.) | 0.5 | $NH_2CONH(CH_2)_3-$ | $(OC_2H_5)$ |
| 18 | A-1160 (U.C.) | 1.0 | $NH_2CONH(CH_2)_3-$ | $(OC_2H_5)$ |
| 19 | A-174 (U.C.) | 0.2 | $H_2C=C(CH_3)-C(O)-O(CH_2)_3-$ | $(OCH_3)$ |
| 20 | A-174 (U.C.) | 0.5 | $H_2C=C(CH_3)-C(O)-O(CH_2)_3-$ | $(OCH_3)$ |
| 21 | A-175 (U.C.) | 0.2 | $H_2C=C(CH_3)-C(O)-O(CH_2)_3-$ | $(OC_2H_4OCH_3)$ |
| 22 | A-175 (U.C.) | 0.5 | $H_2C=C(CH_3)-C(O)-O(CH_2)_3-$ | $(OC_2H_4OCH_3)$ |

13

| Sample No. | Product Identification | % Conc. | R Group | X Group |
|---|---|---|---|---|
| 23 | Z-6032 (D.C.) | 0.2 | $CH_2=CH$ phenyl$-CH_2\overset{H}{N}(CH_2)\overset{H}{N}(CH_2)_3-$ | $(OCH_3)\cdot HCl$ salt[3] |
| 24 | Z-6032 (D.C.) | 0.5 | $CH_2=CH$ phenyl$-CH_2\overset{H}{N}(CH_2)\overset{H}{N}(CH_2)_3-$ | $(OCH_3)\cdot HCl$ salt[3] |
| 25 | Z-6030 (D.C.) | 0.2 | $H_2C=\underset{CH_3}{C}-\overset{O}{C}-O(CH_2)_3-$ | $(OCH_3)$ |
| 26 | Z-6030 (U.C.) | 0.5 | $H_2C=\underset{CH_3}{C}-\overset{O}{C}-O(CH_2)_3-$ | $(OCH_3)$ |
| 27 | D-6110 (P.C.) | 0.2 | $[phenyl]P-(CH_2)_2-$ | $(OC_2H_5)$ |
| 28 | D-6110 (P.C.) | 0.5 | $[phenyl]P-(CH_2)_2-$ | $(OC_2H_5)$ |
| 29 | Dynasylan (P.C.) Imeo | 0.2 | $H_2C-CH_2$ with $N$ and $N-(CH_2)_3$ bridged by $\overset{H}{C}$ | $(OC_2H_5)$ |
| 30 | Dynasylan (P.C.) Imeo | 0.5 | $H_2C-CH_2$ with $N$ and $N-(CH_2)_3$ bridged by $\overset{H}{C}$ | $(OC_2H_5)$ |
| 31 | T-2500-5 (P.C.) | 0.2 | $H_3C\overset{O}{C}NHCH_2\overset{O}{C}NH(CH_2)_3-$ | $(OC_2H_5)$ |
| 32 | T-2500-5 (P.C.) | 0.5 | $H_3C\overset{O}{C}NHCH_2\overset{O}{C}NH(CH_2)_3-$ | $(OC_2H_5)$ |
| 33 | A-0698 (P.C.) | 0.2 | $CH_2CH_2-$ phenyl $CH_2NH(CH_2)_2NH_2$ | $(OCH_3)$ |
| 34 | A-0698 (P.C.) | 0.5 | $CH_2CH_2-$ phenyl $CH_2NH(CH_2)_2NH_2$ | $(OCH_3)$ |

14

| Sample No. | Product Identification | % Conc. | R Group | X Group |
|---|---|---|---|---|
| 35 | T-2921 (P./C.) | 0.2 | $H_2N$, $H_2N$ — $C=S^+$ ($Cl^-$) — $CH_2$, —$(CH_2)_2$— | $(OCH_3)$ |
| 36 | T-2921 (P./C.) | 0.5 | $H_2N$, $H_2N$ — $C=S^+$ ($Cl^-$) — $CH_2$, —$(CH_2)_2$— | $(OCH_3)$ |
| 37 | Prosil 9214 (P.C.R.) | 0.25 | | – |
| 38 | Prosil 5214 (P.C.R.) | 0.50 | | – |
| 39 | Prosil 5214 (P.C.R.) | 0.75 | | – |
| 40 | P-0111 (P.C.) | 0.2 | $\text{C}_6\text{H}_4(CH_3)$—$CH$—$NH$—$\overset{O}{\overset{\|}{C}}$—$NH$—$(CH_2)_2$— | $(OC_2H_5)$ |
| 41 | P-0111 (P.C.) | 0.5 | $\text{C}_6\text{H}_4(CH_3)$—$CH$—$NH$—$\overset{O}{\overset{\|}{C}}$—$NH$—$(CH_2)_2$— | $(OC_2H_5)$ |

D.C. = Dow Chemical
U.C. = Union Carbide
P.C. = Petrarch Systems Inc.
P.C.R = P.C.R Incorporated

Coatings of coupling agent solution were made on cleaned copper foil as well as cleaned copper foil treated with immersion tin composition of Example 1, by dipping the foil samples in hydrolyzed silane solution for approximately 15 seconds. removing the sample and allowing to air dry. Once dried, samples were placed in a hot air oven set at approximately 105°C for 5 minutes. All samples were dried at this temperature and time, which included immersion tin with no silane treatment and brown and black oxide treated samples.

The treated samples were then placed in contact with either epoxy or polyimide prepreg and laminated in a conventional manner using a WABASH PRESS.

Press conditions for Norplex Type BG-2X1 epoxy prepreg were:

1. Preheat press to 177°C ± 3°C (350°F ± 5°)

2. Load and center package as rapidly as possibly

3. Close press to full pressure to 2,069•10⁶ Pa (300 psi)

4. Allow to cure for 60 minutes ± 5 minutes at 177°C (350°F)

5. Cool press under full load to 66°C (150°F) or less

6. Remove samples

Press conditions for Norplex Type BG-230 polyimide prepreg were:

15

1. Preheat press to 121°C ± 3°C (250°F ± 5°F)

2. Load and center package

3. Immediately apply pressure of 4,137•10$^6$ Pa (600 psi)

4. Heat press, at 3°C/minute (5°F/minute) (no greater than 6°C/minute (10°F/minute)) to 218°C ± 3°C (425°F ± 5°F)

5. Hold at 218°C (425°F) for total cure time of 4 hours

6. Cool load under full pressure to 66°C (150°F) or less, then remove samples.

All samples are cut into 1,27 cm (one-half inch) strips and bond strength determined on an INSTRON tester in accordance with its procedure for measurement.

| | | | Bond Strength (lbs/inch) g/cm | | | |
| | | | Polyimide | | Epoxy | |
| Sample No. | Product Description | Conc. % of silane | Copper | Immersion Tin | Copper | Immersion Tin |
|---|---|---|---|---|---|---|
| – | No coating | – | (0.2)357 | (0.5)89,3 | (1.7)304 | (3.5)625 |
| – | Brown Oxide | – | (1.2)214 | – | (5.7)1018 | – |
| – | Black Oxide | – | (1.6)286 | – | (6.1)1089 | – |
| 1 | A-151 | 0.5 | (0.1)179 | (1.8)321 | (1.3)232 | (2.0)357 |
| 2 | A-151 | 1.0 | (0.1)179 | (1.5)268 | (1.6)286 | (3.2)572 |
| 3 | A-186 | 0.5 | (0.1)179 | (1.8)321 | (1.5)268 | (3.2)572 |
| 4 | A-186 | 1.0 | (0.1)179 | (1.3)232 | (1.5)" | (2.2)393 |
| 5 | A-187 | 0.5 | (0.1)179 | (1.5)268 | (1.6)286 | (4.3)768 |
| 6 | A-187 | 1.0 | (0.1)179 | (1.8)321 | (1.5)268 | (5.5)982 |
| 7 | A-1100 | 0.5 | (0.2)357 | (1.4)250 | (0.7)125 | (4.0)714 |
| 8 | A-1100 | 1.0 | (0.2)357 | (0.7)125 | (0.6)107 | (2.5)447 |
| 9 | A-1102 | 0.5 | (0.1)179 | (0.8)143 | (0.8)143 | (3.3)589 |
| 10 | A-1102 | 1.0 | (0.2)357 | (0.6)107 | (0.4)71,4 | (2.8)500 |
| 11 | A-1110 | 0.5 | (0.2)" | (1.3)232 | (1.2)214 | (4.0)714 |
| 12 | A-1110 | 1.0 | (0.3)536 | (1.3)" | (1.3)232 | (4.5)804 |
| 13 | A-1120 | 0.5 | (0.4)71,4 | (0.4)71,4 | (0.9)161 | (2.0)357 |
| 14 | A-1120 | 1.0 | (0.3)536 | (0.5)89,3 | (0.7)125 | (2.0)" |
| 15 | A-1130 | 0.5 | (0.3)" | (1.2)214 | (0.9)161 | (2.9)518 |
| 16 | A-1130 | 0.5 | (0.5)893 | (0.8)143 | (0.9)" | (2.1)375 |
| 17 | A-1160 | 0.5 | (0.1)179 | (2.5)447 | (1.2)214 | (6.0)1072 |
| 18 | A-1160 | 1.0 | (0.1)" | (1.8)321 | (1.3)232 | (5.5)982 |
| 19 | A-174 | 0.2 | (0.2)357 | (2.3)411 | (1.7)304 | (4.4)786 |
| 20 | A-174 | 0.5 | (0.3)536 | (1.5)268 | (1.1)196 | – |
| 21 | A-175 | 0.2 | (0.2)357 | (2.8)500 | (1.6)286 | (4.6)822 |
| 22 | A-175 | 0.5 | (0.2)" | (1.5)268 | (1.1)196 | (4.0)714 |
| 23 | Z-6032 | 0.2 | (0.2)" | (1.9)339 | (1.8)321 | (5.6)1000 |
| 24 | Z-6032 | 0.5 | (0.2)" | (1.3)232 | (0.9)161 | (4.7)839 |
| 25 | 7-6030 | 0.2 | (0.3)536 | (2.2)393 | (1.7)304 | (4.5)804 |
| 26 | Z-6030 | 0.5 | (0.2)357 | (1.9)339 | (1.0)179 | (4.6)822 |
| 27 | D-6110 | 0.2 | (0.2)" | (0.4)71,4 | (2.0)357 | (3.0)536 |
| 28 | D-6110 | 0.5 | (0.2)" | (0.5)89,3 | (1.3)232 | (2.9)518 |
| 29 | Dynasylan Imeo | 0.2 | (0.3)536 | (1.6)286 | (1.9)339 | (6.3)1125 |
| 30 | Dynasylan Imeo | 0.5 | – | (1.3)232 | (1.1)196 | – |
| 31 | T-2500-5 | 0.2 | (0.2)357 | (1.4)250 | (2.1)375 | (4.6)822 |
| 32 | T-2500-5 | 0.2 | (0.2)" | (1.4)" | (2.1)" | (4.6)" |
| 33 | A-0698 | 0.2 | – | (0.8)143 | (1.1)196 | (4.2)750 |
| 34 | A-0698 | 0.5 | (0.5)893 | (1.4)250 | (0.8)143 | – |
| 35 | T-2921 | 0.2 | (0.2)357 | (2.5)447 | (1.4)250 | (6.3)1125 |
| 36 | T-2921 | 0.5 | (0.5)893 | (1.7)304 | (0.8)143 | (4.3)768 |
| 37 | Prosil 9214 | 0.25 | – | (3.7)661 | – | (4.9)875 |
| 38 | Prosil 9214 | 0.50 | – | (3.5)625 | – | (5.7)1018 |
| 39 | Prosil 9214 | 0.75 | – | (3.5)" | – | (5.3)947 |
| 40 | P-0111 | 0.2 | (0.4)71,4 | (1.2)214 | (1.7)304 | (5.5)982 |
| 41 | P-0111 | 0.5 | (0.2)357 | (1.2)214 | (1.2)214 | (4.8)857 |

EXAMPLE 4

Copper foil, 35 μm (1.4 mil) thick (1 oz. = 28,4g copper) was chemically cleaned, treated with an immersion tin formulation ST.240 (which does not contain urea) recommended by its manufacturers CuTech, Inc. for use as a multilayer bonder and a silane coupling agent. gamma-ureidopropyltriethoxysilane and evaluated versus the immersion tin composition without silane treatment.

Samples of copper foil were taped to an epoxy support panel, exposing an area approx. 46cm x 30cm (18"x12") of copper for treatment. The panels were processed as follows prior to immersion tin treatment:

1. AC-500 (Du Pont) acidic cleaner - 3 minutes at 54°C (130°F)

2. Two - 1 minute cold water rinses

3. Microtech - two minutes at room temperature with sodium persulfate

4. Two - 1 minute cold water rinses

5. 1 minute dip in 10% by volume sulfuric acid at room temperature

6. 1 minute cold water rinse

7. Dry

Prior to immersion plating, cleaned copper samples were dipped in a 5% hydrochloric acid solution then immediately dipped into the immersion tin bath. Several temperatures and times, as indicated below, were studied.

1. Room temp. (approx. 20°C) - 1 minute immersion

2. 49°C - 1 minute immersion

3. 49°C - 5 minute immersion

4. 49°C - 15 minute immersion

Following plating, all samples were water rinsed (room temperature water) for 3 minutes and allowed to air dry.

Two samples, approx. 15cm x 23cm (6"x9") in dimension, from each plating condition were then dipped, for approximately 30 seconds, in a 0.5% solution of A-1160, organofunctional silane used in Example 1, prepared by adjusting the pH of deionized water to approximately 3.5 with acetic acid, adding the silane and allowing to stand approximately 30 minutes before use. Two samples from each plating condition acted as controls (i.e., no silane treatment). Also included as controls, were samples of the immersion tin formulation of Example 1. Cleaning conditions prior to immersion plating were as per CuTech samples, except for the 5% hydrochloric acid dip. Immersion plating conditions were 1 minute at room temperature (approx. 20°C). following by rinsing with room temperature water for approx. 2 minutes, then air drying.

All samples were heat treated at 127-132°C for 1 hour as described in Example 1.

Lamination of samples to both epoxy and polyimide prepreg were as per Example 3.

Laminated samples were cut into 1.27 cm (one-half inch) strips and bond strength determined on an Instron Tester.

| Results | | | | |
|---------|---|---|---|---|
| Sample | Bond Strength (lbs/inch) g/cm | | | |
| | Epoxy | | Polyimide | |
| | w/o Silane | with Silane | w/o Silane | with Silane |
| CuTech @ R.T. 1 min. immersion | (2.8) 500 | (5.8) 1036 | (0.3) 53,58 | (3.3) 589 |
| CuTech @ 49°C (120°F) 1 min. immersion | (2.2) 393 | (4.3) 768 | (0.6) 107 | (2.0) 357 |
| CuTech @ 49°C (120°F) 5 min. immersion | (3.5) 625 | (5.8) 1036 | (0.2) 35,72 | (2.5) 447 |
| CuTech @ 49°C (120°F) 15 min. immersion | (3.5) 625 | (5.2) 929 | (0.6) 107 | (2.6) 464 |
| Example 1 Immersion tin @ R.T. -1 min. immersion | (3.5) 625 | (6.2) 1107 | (0.1) 17,86 | (2.7) 482 |

EXAMPLE 5

Evaluation of silane coupling agent A-1160 applied to various metal/metal oxide surfaces.

A number of metal surfaces ranging from very "noble" gold to very "non-noble" or "active" aluminum was evaluated to determine the effect of treating these surfaces with silane coupling agent A-1160.

Aluminum

Aluminum foil. 152 μm (6 mils) thick, was pumice scrubbed (Etchomatic, acid 4F pumice) to remove surface contamination. Two samples, approximately 15cm x 23 cm (6"x9") in dimension, were then dipped into a 0.5% solution of A-1160 organofunctional silane coupling agent for approximately 30 seconds, removed and allowed to air dry. Two additional samples, also 15cm x 23cm (6"x9") were prepared which did not receive silane treatment and served as controls.

All samples were heated to 93-104°C for one hour as described in Example 1.

Lamination of samples to bath epoxy and polyimide prepreg are as per Example 3.

Nickel

Samples of nickel were prepared by
1. Cleaning 28,4g (1 oz.) (1.4 mil = 35 $\mu$m) copper foil as follows:
   A. Du Pont AC-500 acid cleaner @ 54°C for 5 min.
   B. Water rinse - 2 min.
   C. Sodium persulfate microtech - 3 minutes at room temperature
   D. Water Rinse - 2 minutes at room temperature
   E. 10% sulfuric acid dip - 1 min. at room temp.
   F. Water rinse - spray - 30 seconds
2. Electroplate cleaned foil with Lea Ronal GLEAM PCM (with air agitation) -269 A/m$^2$ (25 amps per ft$^2$)
   A. Spray water rinse - 30 seconds
   B. 10% sulfuric acid dip - 1 min. @ R.T.
   C. Spray water rinse - 30 seconds
3. Nickel plate (Harstan Nickel sulfamate bath) at 52-54°C -269 A/m$^2$ (25 amps per ft$^2$) - 12 minutes for 7,6 $\mu$m (0.3 mil) thick plating
   A. Spray water rinse - 60 seconds
   B. 10% sulfuric acid dip - 1 min. at room temp.
   C. Spray water rinse - 30 seconds
   D. Air dry

Two samples, approximately 15 x 23 cm (6"x9") were dipped for approx. 30 seconds in a 0.5% solution of A-1160 organofunctional silane, prepared by adjusting the pH of deionized water to approximately 3.5 with acetic acid adding silane and allowing to stand approximately 30 minutes before use. Two additional samples, also 15cm x 23cm (6"x9") were prepared which did not receive silane treatment.

Also included as controls, were samples of Example 1 immersion tin. Samples were processed as per Example 3. Two samples 15cm x 23cm (6"x9"), were treated with A-1160 silane and two samples, 15cm x 23cm (6"x9") remains untreated.

All samples were heat treated at 127-132°C for 1 hour as described in Example 1.

Lamination of samples to both epoxy and polyimide prepreg were as per Example 3.

Gold

Samples of electroplated gold were prepared, following the procedure outlined above for nickel however, after step 3(c), samples were placed in gold plating bath (OROSENE 999) containing gold cyanide. The plating bath was controlled at 35-38°C and 75 A/m$^2$ (7 amps per ft$^2$). A ten minute plating cycle produced approximately 2,5 $\mu$m (0.1 mil) of gold. Following plating the samples were spray rinsed with water for 30 seconds followed by drying.

Two samples, approximately 6"x9" were dipped for approximately 30 seconds in A-1160 silane coupling agent as per aluminum example reported previously. Two additional samples were prepared which served as controls (no silane treatment).

Lamination of samples to both epoxy and polyimide prepreg was in accordance with the procedure described in Example 3.

Lamination samples are cut into 1,27 cm (one-half inch) strips and bond strength determined on an INSTRON Tester.

| Results | | | | |
|---|---|---|---|---|
| Substrate Metal | Bond strength (lbs/inch) g/cm | | | |
| | Epoxy | | Polyimide | |
| | w/o Silane | with Silane | w/o Silane | with Silane |
| Aluminum | 1893 (10.6) | 2768 (15.5) | 447 (2.5) | 822 (4.6) |
| Nickel | 89,3 (0.5) | 268 (1.5) | 0 | 35,7 (0.2) |
| Gold | 143 (0.8) | 89,3 (0.5) | 35,7 (0.2) | 0 |
| Ex. 1 Immersion Tin | 661 (3.7) | 1125 (6.3) | 35,7 (0.2) | 500 (2.8) |

EXAMPLE 6

A recent technical paper presented at the Printed Circuit World Convention IV, Tokyo, Japan June 2 to 5, 1987 is stated to be an improvement in conventional techniques of making multilayer printed circuit boards whereby an oxide coating is first formed onto a copper surface prior to bonding to an insulating layer. This paper sets forth that the problem of acid penetration of a bonding surface was eliminated by substitution of metallic copper for the surface oxide. This is accomplished by immersion of copper oxide treated copper directly into a 17.5% hydrochloric acid solution for 5 seconds. It is stated, that "Micro grained oxide crystals are quickly dissolved by the acid solution and they disappear from the treated surface of the brown oxide. On the other hand, minute roughness on the reduced surface still remains on the treated surface even after acid immersion".

Subsequent lamination of this "minute" roughened surface to polyimide prepreg reportedly provides a bond strength comparable to copper oxide treatment without the undesirable chemical attack associated with copper oxide. i.e., pink ring. This example examines the effect of

1. Hydrolyzing copper oxide surface in acidic aqueous solution,
2. Applying immersion tin to the hydrolyzed surface,
3. Applying a silane coupling agent to the immersion tin coating.

Four samples of copper foil, 35 $\mu$m (1.4 mil) thick were treated with Electrochemicals 499 brown oxide as per Example 1. The samples were then immersed in 18% hydrochloric acid solution for 5-10 seconds, removed and rinsed with water for approximately 1 minute. Two of the samples, 15 cm x 23 cm (6"x9"), were then processed in immersion tin as per Example 3. Two samples, 15 cm x 23 cm, (6"x9"), were left unplated.

The immersion tin plated samples were then treated with a 0.5% solution of A-1160 silane coupling agent as per Example 5. All samples (silane treated immersion tin plated plus unplated samples) were heat treated at 127-132°C for 1 hour as described in Example 1.

Lamination of samples to both epoxy and polyimide prepreg was as per Example 3. Included in the lamination were samples of copper foil treated with Electrochemical 499 brown oxide.

All laminated samples were cut into 1,27 cm (one-half inch) strips and bond strength determined on an INSTRON test apparatus.

| Results | | |
|---|---|---|
| Sample | Bond Strength (lbs/inch) g/cm | |
| | Epoxy | Polyimide |
| Electrochemicals 499 Brown Oxide | (6.5)1161 | (0.6)107 |
| Example 1 applied to hydrolyzed copper oxide surface no silane treatment | (1.7)304 | 0 |
| Immersion Tin applied to hydrolyzed copper oxide surface-treated with A-1160 silane | (7.4)1322 | (5.6)1000 |

EXAMPLE 7

Bond strength stability as a function of post-bake time was evaluated.

Four samples, approximately 15 cm x 23 cm(6"x9"), of immersion tin treated copper were prepared in accordance with the procedure of Example 3. Two samples were treated with 0.5% A-1160 silane coupling agent pursuant to the procedure of Example 5. The remaining samples were left untreated.

Two copper foil samples 35 $\mu$m (1.4 mil) and 30 cm x 23 cm (12"x9") in dimension were treated with Electrochemicals 499 brown oxide as in Example 1. The samples were then cut into half to generate four 15 cm x 23 cm (6"x9") samples.

Four samples of copper foil, 35 $\mu$m (1.4 mil) thick, and 15 cm x 23 cm (6"x9") were chemically cleaned as described in Example 5.

All samples were then heat treated at 127-132°C for 1 hour as described in Example 1.

Lamination to epoxy and polyimide prepreg was then accomplished as in Example 3.

Laminated samples were cut into 1,27 cm (one-half inch) strips and bond strength determined on an INSTRON tester. Additional samples were prepared for bond strength determination, however, prior to testing, portions were post-baked for 1 hour in a hot air oven set at 177°C (350°F) for epoxy and 221°C (430°F) for polyimide. Samples were also heat treated at the above indicated temperature for 3 and 6 hour periods. Bond strengths were then determined as indicated below for both epoxy and polyimide.

| | EPOXY | | | |
|---|---|---|---|---|
| | Bond strength g/cm (lbs/inch) Various Post Bake Times at 177°C (350°F) | | | |
| | 0 | 1 | 3 | 6 |
| Immersion Tin - No silane | (3.4) 607 | (3.2) 572 | (3.8) 679 | (0.4) 71,4 |
| Immersion Tin with A-116O silane | (7.2) 1286 | (6.8) 1214 | (6.4) 1143 | (5.8) 1036 |
| Chemically cleaned copper | (2.3) 411 | (1.0) 179 | (0.9) 161 | (0.6) 107 |
| Electrochemicals 499 Brown Oxide | (8.4) 1500 | (3.5) 625 | (2.4) 429 | (1.2) 214 |

| | Polyimide | | | |
|---|---|---|---|---|
| | Bond strength g/cm (lbs/inch) Various Post Bake Times at 221°C (430°F) | | | |
| | 0 | 1 | 3 | 6 |
| Immersion Tin - No silane | (0.4) 71,4 | (0.4) 71,4 | (0.5) 89,3 | (0.5) 89,3 |
| Immersion Tin with A-1160 silane | (4.8) 857 | (5.1) 911 | (5.5) 982 | (5.3) 947 |
| Chemically cleaned copper | (0.2) 35,7 | (0.2) 35,7 | (0.2) 35,7 | (0.2) 35,7 |
| Electrochemicals 499 Brown Oxide | (0.6) 107 | (0.5) 89,3 | (0.6) 107 | (0.6) 107 |

EXAMPLE 8

The general procedures of Example 1 were followed except panels were processed through an inline spray system at a conveyor speed of 1,22 m/min (4 feet per minute).

| | CONVEYOR LENGTH cm | RINSE WATER FLOW | (SOLUTION) TEMP °C (°F) | SPRAY PRESSURE (PSI) $Pa \cdot 10^3$ |
|---|---|---|---|---|
| 1. Panel Feed (Input) | (23") 58,4 | --- | --- | --- |
| 2. Alkaline Cleaner (Electro Chemicals 402LS) | (20") 50,8 | --- | (120) 49 | (25) 172 |
| 3. Water Rinse | (20") 50,8 | (5 GPM*) 18,9 ℓ/min | (60) 16 | (20) 138 |
| 4. Microetch (Sodium Persulfate/ Sulfuric Acid) | (27") 68,6 | --- | (110) 43 | (25) 172 |
| 5. Water Rinse | (20") 50,8 | (5 GPM) 18,9 ℓ/min | (60) 16 | (20) 138 |
| 6. Immersion Tin Application (Composition of Ex. 1) | (48") 122 | --- | (75) 24 | (25) 172 |
| 7. Water Rinse (Recycle) | (20") 50,8 | --- | (110) 43 | (25) 172 |
| 8. Water Rinse followed by air knife drying | (20") 50,8 | (5 GPM) 18,9 ℓ/min | (60) 16 | (20) 138 |
| 9. Silane Treatment (Composition of Ex. 1) | (20") 50,8 | --- | (75) 24 | (25) 172 |
| 10. Hot Air Dryer | (30") 76,2 | --- | (130) 54 | --- |
| 11. Output Conveyor | (41") 104 | --- | --- | --- |

*GPM is gallons per minute

## Claims

1. A process for forming a multilayer printed circuit board containing conductive through-holes which make electrical connections to a series of electrically conducting layers through several insulating layers comprising the steps of:

22

(a) forming electrically conductive copper circuitry on a surface of a dielectric layer support with the circuitry having a thickness of at least 4 microns:

(b) forming on the copper circuitry a layer of an oxide, hydroxide or combination thereof of copper or a less noble multivalent metal by (i) conversion of the copper circuitry surface to copper oxide or (ii) application of copper or a less noble multivalent metal to the copper circuitry whereby during application or subsequent thereto the applied metal is converted on its surface to the oxide, hydroxide or combination thereof with the proviso that during (i) or (ii) the layer of oxide, hydroxide or combination is not greater than 1.5 microns in thickness:

(c) forming an adherent organosilane coating on the surface of the-oxide. hydroxide or combination thereof formed in step (b) or on an insulating layer to be bonded to the copper circuitry, the insulating layer comprising a partially cured thermosetting polymer composition;

(d) repeating steps (a), (b) and (c);

(e) bonding materials formed by steps (a), (b), (c) and (d) into a single article whereby an organosilane coating is between a layer of the oxide, hydroxide or combination and an insulating layer whereby during bonding the partially cured insulating layer is cured;

(f) forming a number of holes through the article composites formed in step (e);

(g) metallizing walls of the through-holes to form electrically conductive paths from opposite openings of the through-hole to form a multilayer circuit board with the proviso that the multi layer printed circuit board will not delaminate upon, exposure to thermal stress at 288°C (550°F) for 10 seconds after a pre-conditioning bake at 135-149°C (275-300°F) for two (2) hours.

2. The process of claim 1 wherein steps (a) to (d) include two insulating layers wherein a second dielectric layer contacts the first insulating layer directly or through an adhesive or insulating layer.

3. The process of claim 1 wherein steps (a) to (d) comprise one insulating layer supporting a layer of copper circuitry, with the proviso that the next step(a) is not repeated in step (d).

4. The process of claim 1 wherein the dielectric layer contains copper circuitry on two opposite surfaces.

5. The process of claim 1 in which the multivalent metal is tin.

6. The process of claim 2 in which the tin is applied by an immersion process.

7. The process of claim 1 in which the silane adhesion promoter is gamma-ureidoalkyltriethoxysilane.

8. The process of claim 1 in which the dielectric layer contains glass epoxy or polyimide.

9. The process of claim 1 in which the circuit board will not delaminate upon exposure at 288°C (550°F) for 60 seconds.

10. A multilayer printed circuit board containing conductive through-holes which make electrical connections to a series of electrically conducting layers through several insulating layers comprising:

(a) a dielectric layer;

(b) copper circuitry having a thickness of at least 4 microns;

(c) a layer of an oxide, hydroxide or combination thereof of copper or a less noble multivalent metal of a thickness not greater than 1.5 microns which overlies the copper of (b) or overlies a less noble multivalent metal;

(d) an organosilane layer;

(e) an insulating layer comprising a cured thermosetting polymer composition;

(f) a dielectric layer; -

(g) copper circuitry having a thickness of at least 4 microns;

(h) a layer of an oxide, hydroxide or combination thereof of copper or a less noble multivalent metal of a thickness not greater than 1.5 microns which overlies the copper of (b) or overlies a less noble multivalent metal;

(i) an organosilane layer;

(j) an insulating layer comprising a cured thermosetting polymer composition;

with the proviso that the multilayer printed circuit board will not delaminate upon exposure to thermal stress at 288°C (550°F) for 10 seconds after a pre-conditioning bake at 135-149°C (275-300°F) for

EP 0 310 010 B1

two (2) hours.

**11.** A multilayer printed circuit board containing conductive through-holes which make electrical connections to a series of electrically conducting layers through several insulating layers comprising:

(a) a dielectric layer;

(b) copper circuitry having a thickness of at least 4 microns;

(c) a layer of an oxide, hydroxide or combination thereof of copper or a less noble multivalent metal of a thickness not greater than 1.5 microns which overlies the copper of (b) or overlies a less noble multivalent metal;

(d) an organosilane layer;

(e) an insulating layer comprising a cured thermosetting polymer composition.

(f) an organosilane layer:

(g) a layer of an oxide, hydroxide or combination thereof of copper or a less noble multivalent metal of a thickness not greater than 1.5 microns which overlies the copper of (h) or overlies a less noble multivalent metal;

(h) copper circuitry having a thickness of at least 4 microns;

(i) a dielectric layer;

with the proviso that the multilayer printed circuit board will not delaminate upon exposure to thermal stress at 288°C (550°F) for 10 seconds after a pre-conditioning bake at 135-149°C (275-300°F) for two (2) hours.

**12.** A multilayer printed circuit board containing conductive through-holes which bake electrical connections to a series of electrically conducting layers through several insulating layers comprising:

(a) a dielectric layer;

(b) copper circuitry having a thickness of at least 4 microns;

(c) a layer of an oxide, hydroxide or combination thereof of copper or a less noble multivalent metal of a thickness not greater than 1.5 microns which overlies the copper of (b) or overlies a less noble multivalent metal;

(d) an organosilane layer;

(e) an insulating layer comprising a cured thermosetting polymer composition;

(f) copper circuitry having a thickness of at least 4 microns;

(g) a layer of an oxide, hydroxide or combination thereof of copper or a less noble multivalent metal of a thickness not greater than 1.5 microns which overlies the copper of (b) or overlies a less noble multivalent metal;

(h) an organosilane layer;

(i) an insulating layer comprising a cured thermosetting polymer composition;

with the proviso that the multilayer printed circuit board will not delaminate upon exposure to thermal stress at 288°C (550°F) for 10 seconds after a pre-conditioning bake at 135-149°C (275-300°F) for (2) hours.

**Patentansprüche**

**1.** Verfahren zur Herstellung einer mehrschichtigen, gedruckten Leiterplatte, die leitende Durchgangslöcher enthält, welche elektrische Verbindungen zu einer Anzahl von elektrisch leitenden schichten durch verschiedene Isolierschichten herstellen, umfassend die Stufen:

a) Bildung einer elektrisch leitenden Kupferschaltung auf einer Oberfläche einer dielektrischen Trägerschicht, wobei die Schaltung eine Dicke von mindestens 4 μm aufweist;

b) Bildung einer Schicht eines Oxids, Hydroxids oder deren Kombination, aus Kupfer oder einem weniger edlen, mehrwertigen Metall auf der Kupferschaltung durch (i) Umwandlung der Kupferschaltungs-Oberfläche in Kupferoxid oder (ii) Anwendung von Kupfer oder eines weniger edlen, mehrwertigen Metalls für die Kupferschaltung, wobei während der Anwendung oder danach das angewandte Metall an seiner Oberfläche in das Oxid, Hydroxid oder deren Kombination umgewandelt wird, mit der Maßgabe, daS während (i) oder (ii) die Schicht aus Oxid, Hydroxid oder deren Kombination nicht größer als 1,5 μm dick ist;

c) Bildung einer haftenden Organosilan-Beschichtung auf der in Stufe b) gebildeten Oberfläche des Oxids, Hydroxids oder deren Kombination oder auf einer Isolierschicht, die an der Kupferschaltung zu binden ist, wobei die isolierende Schicht eine teilweise gehärtete, warmhärtbare polymer-Zusammensetzung umfaßt;

24

d) wiederholen der Stufen a), b) und c);

e) des Verbindens der durch die Stufen a), b), c) und d) gebildeten Materialien zu einem einzigen Gegenstand, wobei eine Organosilan-Beschichtung zwischen einer Schicht des Oxids, Hydroxids oder deren Kombination und einer Isolierschicht vorliegt und wobei während des Verbindens die teilweise gehärtete Isolierschicht gehärtet wird;

f) Bildung einer Anzahl von Löchern, durch den in der Stufe gebildeten Composit-Gegenstand;

g) Metallisieren der Wände der Durchgangslöcher zur Ausbildung elektrischer Leiterbahnen von gegenüberliegenden Öffnungen des Durchgangslochs, um eine mehrschichtige, gedruckte Leiterplatte herzustellen, mit der Maßgabe, daß wenn die mehrschichtige gedruckte Leiterplatte einer thermischen Beanspruchung von 288 °C (550 °F) während 10 Sekunden, nach einer vorbehandelnden Härtung bei 135-149 °C (275-300 °F) während zwei Stunden ausgesetzt ist, nicht delaminiert.

2. Verfahren nach Anspruch 1, worin die Stufen a) bis d) zwei Isolierschichten umfassen, worin die zweite dielektrische Schicht direkt mit der ersten Isolierschicht oder durch ein Haftmittel oder eine Isolierschicht in Kontakt steht.

3. Verfahren nach Anspruch 1, worin die Stufen a) bis d) eine Isolierschicht umfassen, die eine Schicht aus einer Kupferschaltung trägt, mit der Maßgabe, daß die nächste Stufe a) nicht in Stufe d) wiederholt wird.

4. Verfahren nach Anspruch 1, worin die dielektrische Schicht eine Kupferschaltung auf zwei gegenüberliegenden Oberflächen enthält.

5. Verfahren nach Anspruch 1, worin das mehrwertige Metall Zinn ist.

6. Verfahren nach Anspruch 2, worin das Zinn durch ein Eintauchverfahren aufgebracht wird.

7. Verfahren nach Anspruch 1, worin der Silan-Haftpromoter $\gamma$-Ureidoalkyltriethoxysilan ist.

8. Verfahren nach Anspruch 1, worin die dielektrische Schicht Epoxy-Glas oder Polyimid enthält.

9. Verfahren nach Anspruch 1, worin die Leiterplatte, wenn sie 288 °C (550 °C) während 60 Sekunden ausgesetzt wird, nicht delaminiert.

10. Mehrschichtige, gedruckte Leiterplatte, die leitende Durchgangslöcher enthält, welche elektrische Verbindungen zu einer Anzahl von elektrisch leitenden Schichten durch verschiedene Isolierschichten herstellen, umfassend:

a) eine dielektrische Schicht;

b) eine Kupferschaltung mit einer Dicke von wenigstens 4 $\mu$m;

c) eine Schicht eines Oxids, Hydroxids oder deren Kombination, aus Kupfer oder einem weniger edlen, mehrwertigen Metall einer Dicke von nicht mehr als 1,5 $\mu$m, welche das Kupfer von b) oder ein weniger edles mehrwertiges Metall bedeckt;

d) eine Organosilanschicht

e) eine Isolierschicht, die eine gehärtete wärmehärtbare Polymer-Zusammensetzung umfaßt;

f) eine dielektrische Schicht;

g) eine Kupferschaltung mit einer Dicke von wenigstens 4 $\mu$m.

h) eine Schicht eines Oxids, Hydroxids oder deren Kombination, aus Kupfer oder einem weniger edlen, mehrwertigen Metall einer Dicke von nicht mehr als 1,5 $\mu$m, welche das Kupfer von b) oder ein weniger edles mehrwertiges Metall bedeckt;

i) eine Organosilanschicht;

j) eine Isolierschicht, die eine gehärtete wärmehärtbare polymer-Zusammensetzung umfaßt;

mit der Maßgabe, daß die mehrschichtige, gedruckte Leiterplatte, wenn sie einer thermischen Beanspruchung von 288 °C (550 °F) während 10 Sekunden, nach einer vorbehandelnden Härtung bei 135-149 °C (275-300 °F) während zwei Stunden ausgesetzt wird, nicht delaminiert.

11. Mehrschichtige, gedruckte Leiterplatte, die leitende Durchgangslöcher enthält, welche elektrische Verbindungen zu einer Anzahl von elektrisch leitenden Schichten durch verschiedene Isolierschichten herstellen, umfassend:

a) eine dielektrische Schicht;

b) eine Kupferschaltung mit einer Dicke von wenigstens 4 µm;

c) eine Schicht eines Oxids, Hydroxids oder deren Kombination, aus Kupfer oder einem weniger edlen, mehrwertigen Metall einer Dicke von nicht mehr als 1,5 µm, welche das Kupfer von b) oder ein weniger edles mehrwertiges Metall bedeckt;

d) eine Organosilanschicht;

e) eine Isolierschicht, die eine gehärtete wärmehärtbare Polymer-Zusammensetzung umfaßt;

f) eine Organosilanschicht;

g) eine Schicht eines Oxids, Hydroxids oder deren Kombination aus Kupfer oder einem weniger edlen, mehrwertigen Metall einer Dicke von nicht mehr als 1,5 µm, welche das Kupfer von b) oder ein weniger edles mehrwertiges Metall bedeckt;

h) eine Kupferschaltung mit einer Dicke von wenigstens 4 µm.

i) eine dielektrische Schicht;

mit der Maßgabe, daß die mehrschichtige, gedruckte Leiterplatte, wenn sie einer thermischen Beanspruchung von 288 °C (550 °F) während 10 Sekunden, nach einer vorbehandelnden Härtung bei 135-149 °C (275-300 °F) während zwei Stunden ausgesetzt wird, nicht delaminiert.

**12.** Mehrschichtige, gedruckte Leiterplatte, die leitende Durchgangslöcher enthält, welche elektrische Verbindungen zu einer Anzahl von elektrisch leitenden Schichten durch verschiedene Isolierschichten herstellen, umfassend:

a) eine dielektrische Schicht;

b) eine Kupferschaltung mit einer Dicke von wenigstens 4 µm;

c) eine Schicht eines Oxids, Hydroxids oder deren Kombination, aus Kupfer oder einem weniger edlen, mehrwertigen Metall einer Dicke von nicht mehr als 1,5 µm, welche das Kupfer von b) oder ein weniger edles mehrwertiges Metall bedeckt;

d) eine Organosilanschicht;

e) eine Isolierschicht, die eine gehärtete wärmehärtbare Polymer-Zusammensetzung umfaßt;

f) eine Kupferschaltung mit einer Dicke von wenigstens 4 µm;

g) eine Schicht eines Oxids, Hydroxids oder deren Kombination, aus Kupfer oder einem weniger edlen, mehrwertigen Metall einer Dicke von nicht mehr als 1,5 µm, welche das Kupfer von b) oder ein weniger edles mehrwertiges Metall bedeckt;

h) eine Organosilanschicht;

i) eine Isolierschicht, die eine gehärtete wärmehärtbare Polymer-Zusammensetzung umfaßt;

mit der Maßgabe, daß die mehrschichtige, gedruckte Leiterplatte, wenn sie einer thermischen Beanspruchung von 288 °C (550 °F) während 10 Sekunden, nach einer vorbehandelnden Härtung bei 135-149 °C (275-300 °F) während zwei Stunden ausgesetzt wird, nicht delaminiert.

**Revendications**

**1.** Procédé pour former une plaquette multicouches à circuit(s) imprimé(s), contenant des trous traversants conducteurs qui, en traversant plusieurs couches isolantes, assurent des connexions électriques avec une série de couches électriquement conductrices, ce procédé comprenant les étapes consistant à :

(a) former un montage ou un ensemble de circuit(s) en cuivre, électriquement conducteur(s) sur une surface d'un support formé par, ou comprenant, une couche diélectrique, le montage du ou des circuits ayant une épaisseur d'au moins 4 µm.

(b) former sur le montage ou ensemble de circuit(s) en cuivre une couche d'oxyde, hydroxyde ou d'une combinaison d'oxyde et d'hydroxyde de cuivre ou d'un métal multivalent moins noble, par (i) conversion de la surface du ou descircuits de cuivre en de l'oxyde de cuivre ou (ii) application de cuivre ou d'un métal multivalent moins noble, sur le ou les circuits en cuivre et, pendant cette application ou après cette application, convertir la surface du métal ainsi appliqué en l'oxyde, hydroxyde ou une combinaison d'oxyde et d'hydroxyde, à la condition que, pendant (i) ou (ii), la couche d'oxyde, d'hydroxyde ou d'une combinaison d'oxyde et d'hydroxyde n'ait pas une épaisseur supérieure à 1,5 µm.

(c) former un revêtement d'organosilane adhérant à la surface de l'oxyde, de l'hydroxyde ou de la combinaison d'oxyde et d'hydroxyde formé(e) à l'étape (b) ou sur une couche isolante à faire adhérer au(x) circuit(s) en cuivre, la couche isolante comprenant une composition polymère thermodurcissable, partiellement durcie;

(d) répéter les étapes (a), (b) et (c);

(e) relier les matières formées par les étapes (a), (b), (c) et (d) en un article unique, de sorte qu'il existe un revêtement en organosilane entre une couche de l'oxyde, de l'hydroxyde ou d'une combinaison d'oxyde et d'hydroxyde et une couche isolante, de sorte que, pendant la liaison (par collage), la couche isolante partiellement durcie est durcie;

(f) former un certain nombre de trous à travers les matières composites de l'article formé à l'étape (e);

(g) métalliser les parois des trous traversants pour former des trajets électriquement conducteurs à partir des ouvertures opposées des trous traversants afin de former une plaquette multicouches comportant un ou des circuits, à la condition que la plaquette multicouches à circuit(s) imprimé(s) ne se sépare pas en strates ("ne se délamine pas") par exposition à une contrainte thermique de 288°C (550°F) durant 10 secondes après deux (2) heures de cuisson de préconditionnement à 135-149°C (275-300°F).

**2.** Procédé selon la revendication 1, dans lequel les étapes (a) à (d) comprennent l'introduction de deux couches isolantes, une seconde couche diélectrique venant en contact, directement ou par l'intermédiaire d'une couche adhésive ou isolante, avec la première couche isolante.

**3.** Procédé selon la revendication 1, dans lequel les étapes (a) à (d) comprennent l'introduction d'une couche isolante supportant une couche de circuit(s) en cuivre, à la condition que l'étape suivante (a) ne soit pas répétée à l'étape (d).

**4.** Procédé selon la revendication 1, dans lequel la couche diélectrique contient un ou des circuit(s) en cuivre sur deux surfaces opposées.

**5.** Procédé selon la revendication 1, dans lequel le métal multivalent est l'étain.

**6.** Procédé selon la revendication 2, dans lequel l'étain est appliqué par un procédé par immersion.

**7.** Procédé selon la revendication 1, dans lequel le silane, promoteur d'adhérence, est un gammauréidoalkyltriéthoxysilane.

**8.** Procédé selon la revendication 1, dans lequel la couche diélectrique contient de l'époxyde ou du polyimide avec du verre.

**9.** Procédé selon la revendication 1, dans lequel la plaquette à circuit(s) (imprimé(s)) ne subira pas une séparation de ses strates ou "une délamination", en cas d'exposition durant 60 secondes à une température de 288°C (550°F).

**10.** Plaquette multicouches à circuit(s) imprimé(s), la plaquette contenant des trous conducteurs traversants qui, en traversant plusieurs couches isolantes, assurent des connexions électriques avec une série de couches électriquement conductrices, la plaquette comprenant :

(a) une couche diélectrique;

(b) un montage ou ensemble de circuit(s) en cuivre ayant une épaisseur d'au moins 4 $\mu$m;

(c) une couche d'un oxyde, d'un hydroxyde ou d'une combinaison d'oxyde et d'hydroxyde de cuivre ou d'un métal multivalent moins noble, cette couche ayant une épaisseur non supérieure à 1,5 $\mu$m, et qui recouvre le cuivre de (b) ou recouvre un métal multivalent moins noble;

(d) une couche d'un organosilane;

(e) une couche isolante comprenant une composition polymère thermodurcissable, durcie;

(f) une couche diélectrique;

(g) un circuit ou un ensemble de circuits en cuivre ayant une épaisseur d'au moins 4 $\mu$m;

(h) une couche d'un oxyde, d'un hydroxyde ou d'une combinaison d'oxyde et d'hydroxyde de cuivre ou d'un métal multivalent moins noble, cette couche ayant une épaisseur non supérieure à 1,5 $\mu$m, qui recouvre le cuivre de (b) ou recouvre un métal multivalent moins noble

(i) une couche d'organosilane;

(j) une couche isolante comprenant une composition polymère thermodurcissable, durcie;

à la condition que la plaquette multicouches à circuit(s) imprimé(s) ne présente pas une séparation de ses couches (ne se déstratifie pas ou ne se "délamine" pas) en cas d'exposition durant 10 secondes à une contrainte thermique de 288°C (550°F), après une cuisson de préconditionnement effectuée durant deux (2) heures à 135°C-149°C (275-300°F).

**11.** Plaquette multicouches à circuit(s) imprimé(s) contenant des trous conducteurs traversants qui, en traversant plusieurs couches isolantes, assurent des connexions électriques avec une série de couches électriques conductrices, la plaquette comprenant :

(a) une couche diélectrique;

(b) un circuit ou un ensemble de circuits en cuivre ayant une épaisseur d'au moins 4 $\mu$m;

(c) une couche d'un oxyde, d'un hydroxyde ou d'une combinaison d'oxyde et d'hydroxyde de cuivre ou d'un métal multivalent moins noble, cette couche ayant une épaisseur non supérieure à 1,5 $\mu$m, qui recouvre le cuivre de (b) ou recouvre un métal multivalent moins noble;

(d) une couche d'organosilane;

(e) une couche isolante comprenant une composition polymère thermodurcissable, durcie;

(f) une couche d'organosilane;

(g) une couche d'un oxyde, d'un hydroxyde ou d'une combinaison d'oxyde et d'hydroxyde de cuivre, ou d'un métal multivalent moins noble, cette couche ayant une épaisseur non supérieure à 1,5 $\mu$m, qui recouvre le cuivre de (b) ou recouvre un métal multivalent moins noble;

(h) un circuit ou un ensemble de circuits en cuivre ayant une épaisseur d'au moins 4 $\mu$m;

(i) une couche diélectrique;

à la condition que la plaquette multicouches à circuit(s) imprimé(s) ne présente pas de séparation de ses strates (ne se "délamine" pas ou ne se déstratifie pas) en cas d'exposition à une contrainte thermique de 288°C (550°F) appliquée durant 10 secondes après deux (2) heures de cuisson de préconditionnement à 135-149°C (275-300°F).

**12.** Plaquette multicouches à circuit(s) imprimé(s), cette plaquette contenant des trous conducteurs traversants, qui, en traversant plusieurs couches isolantes, assurent des connexions électriques avec une série de couches électriquement conductrices, la plaquette comprenant :

(a) une couche diélectrique;

(b) un circuit ou un ensemble de circuits en cuivre ayant une épaisseur d'au moins 4 $\mu$m;

(c) une couche d'un oxyde, d'un hydroxyde ou d'une combinaison d'oxyde et d'hydroxyde de cuivre ou d'un métal multivalent moins noble, cette couche ayant une épaisseur non supérieure à 1,8 $\mu$m, qui recouvre le cuivre de (b) ou recouvre un métal multivalent moins noble;

(d) une couche d'organosilane;

(e) une couche isolante comprenant une composition polymère thermodurcissable, durcie;

(f) un circuit ou un ensemble de circuit(s) en cuivre ayant une épaisseur d'au moins 4 $\mu$m;

(g) une couche d'un oxyde, d'un hydroxyde ou d'une combinaison d'oxyde et d'hydroxyde de cuivre ou d'un métal multivalent moins noble, la couche ayant une épaisseur non supérieure à 1,5 $\mu$m, qui recouvre le cuivre de (b) ou recouvre un métal multivalent moins noble;

(h) une couche d'organosilane;

(i) une couche isolante comprenant une composition polymère thermodurcissable, durcie,

à la condition que la plaquette multicouches à circuit(s) imprimé(s) ne subisse pas de séparation de ses strates (ne se "délamine" pas ou ne se déstratifie pas) en cas d'exposition durant 10 secondes à une contrainte thermique de 288°C(550°F), après deux (2) heures de cuisson de préconditionnement à 135-149°C (275-300°F).